Europäisches Patentamt

**European Patent Office**

**Office européen des brevets**

(11) Numéro de publication: **0 285 066 B1**

# FASCICULE DE BREVET EUROPEEN

(45) Date de publication de fascicule du brevet: **16.09.92**   (51) Int. Cl.5: **H01L 21/306**, **C04B 41/53**

(21) Numéro de dépôt: **88104981.1**

(22) Date de dépôt: **28.03.88**

(54) **Procédé d'attaque d'une surface d'une pièce en phosphure d'indium.**

(30) Priorité: **01.04.87 FR 8704575**

(43) Date de publication de la demande:
**05.10.88 Bulletin 88/40**

(45) Mention de la délivrance du brevet:
**16.09.92 Bulletin 92/38**

(84) Etats contractants désignés:
**BE DE FR GB IT NL SE**

(56) Documents cités:
**US-A- 4 326 911**

**JOURNAL OF THE ELECTROCHEMICAL SO-CIETY, vol. 133, no. 10, octobre 1986, pages 2204-2205, Manchester, NH, US; K. PAK et al.: "Vapor-phase etching of InP using anhydrous HCl and PH3 Gas"**

**JOURNAL OF VACUUM SCIENCE & TECHNO-LOGY B, vol. 3, no. 5, septembre-octobre 1985, pages 1445-1449, American Vacuum Society, Woodbury, New York, US; M. HIROSE et al.: "Characterization of photochemical processing".**

(73) Titulaire: **ALCATEL CIT**
**12 Rue de la Baume**
**F-75008 Paris(FR)**

(72) Inventeur: **Carrière, Claude**
**32 rue Henriette d'Entragues**
**F-91460 Marcoussis(FR)**
Inventeur: **Renard, Jean**
**99bis rue Ordener**
**F-75018 Paris(FR)**
Inventeur: **Lavolée, Thierry**
**9 rue F.H. Manhes**
**F-91700 Sainte Geneviève des Bois(FR)**

(74) Mandataire: **Weinmiller, Jürgen et al**
**Lennéstrasse 9 Postfach 24**
**W-8133 Feldafing(DE)**

# Description

La présente invention concerne l'attaque d'une surface d'une pièce en phosphure d'indium InP.

Quoique une telle attaque soit susceptible d'être utile dans divers domaines, son application effective est limitée à ce jour à certaines gravures au cours de la fabrication de composants semiconducteurs à base de phosphure d'indium.

La présente invention s'applique plus particulièrement encore à la fabrication de composants optoélectroniques pour des longueurs d'onde de 1,3 micromètre et plus. De tels composants sont utilisés dans le domaine des télécommunications. Les besoins dans ce domaine portent sur des composants de plus en plus évolués, qui sont fabriqués à partir de plaquettes de phosphure d'indium InP monocristallin. Leur réalisation nécessite plusieurs opérations de gravure dans ce matériau.

Au cours de chacune de ces opérations on met en oeuvre un procédé d'attaque pour attaquer une face qui a été préalablement partiellement protégée par un masque. Ce procédé d'attaque constitue donc en même temps un procédé de gravure. Cette attaque fait apparaître, tout le long du bord du masque, un flanc de raccordement entre la zone intacte qui a été protégée par le masque et la zone qui a été creusée par le procédé d'attaque. Le profil de ce flanc dépend du procédé d'attaque ou de gravure choisi et de l'orientation du bord considéré. La zone intacte en surélévation constitue une "mesa" dont un "type" peut être défini par ce profil.

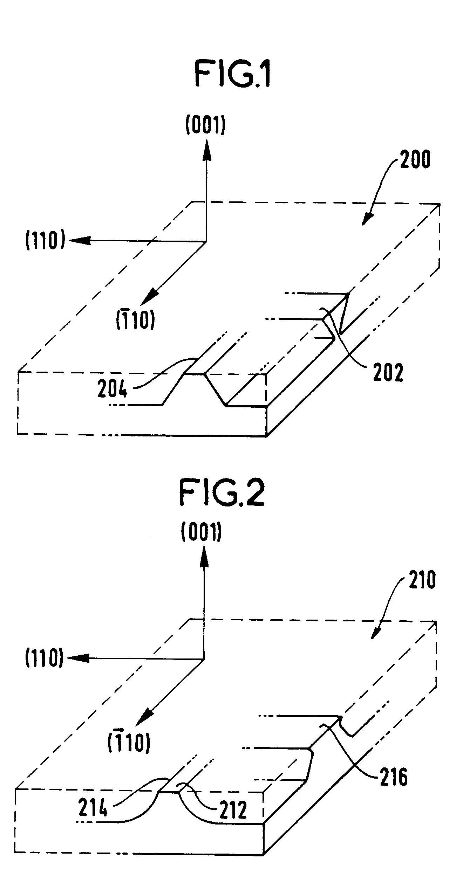

Selon le type de profil désiré plusieurs procédés d'attaque connus peuvent être utilisés. La gravure par voie humide à partir d'une solution de brome-méthanol est actuellement le procédé le plus utilisé dans l'industrie : on part d'une plaquette 200 (voir figure 1) dont la face supérieure à graver est orientée selon un plan (001). Lorsque le masque de protection est un ruban aligné selon la direction (110) on obtient une mésa 202 du type dit inversé. En fait on n'attaque pas le plan (1 Ī 1), le symbole Ī remplaçant ici le chiffre 1 surmonté d'une barre ; par contre une attaque avec un masque aligné selon la direction (Ī10) donne une mesa 204 de type dit normal. Le profil d'attaque est très sensible aux plans cristallins quelle que soit l'orientation : les flancs de la mesa obtenue sont sensiblement plans et forment avec la face supérieure de la mesa un angle aigu dans le premier cas et obtus dans le second cas.

D'autres solutions d'attaque telle que l'acide chlorhydrique dilué peuvent être utilisées pour faire de la gravure par voie humide. Mais il s'agit surtout de procédés de laboratoire difficilement industrialisables.

Les gravures d'InP par voie sèche se font par attaque ionique réactive (en anglais RIE pour "Reactive Ion Etching") en utilisant un plasma constitué à partir de gaz chlorés, et polarisé par rapport à la plaquette à graver. Ce procédé donne des profils d'attaque totalement insensibles aux plans cristallins (mesa à flancs verticaux).

Ces divers procédés connus présentent notamment l'inconvénient de ne pas permettre dans certains cas d'obtenir un profil souhaité, notamment lorsqu'une première mesa en forme de ruban selon une direction longitudinale a été réalisée et présente le type inversé, et lorsqu'une deuxième mésa en forme de ruban selon la même direction longitudinale doit être réalisée en présentant le type normal. Tel est le cas lorsque les flancs de cette deuxième mesa doivent recevoir une couche de passivation efficace.

Une telle couche ne peut en effet pas être obtenue par dépôt sur les flancs d'une mesa inversée. Elle ne peut l'être que très difficilement sur des flancs verticaux.

La présente invention a notamment pour but de permettre dans certains cas d'obtenir un profil de mesa souhaité que les procédés d'attaque connus ne permettent pas d'obtenir.

Elle a aussi pour but de permettre une passivation efficace sur les flancs d'une mesa en forme de ruban dont l'orientation est imposée sur une plaquette semiconductrice monocristalline.

Elle a aussi pour but de permettre d'obtenir une couche superficielle très résistive sur une surface attaquée d'une pièce monocristalline.

Elle a encore pour but de permettre de réaliser une attaque à l'aide de produits peu dangereux, peu coûteux, et faciles à manipuler.

Pour atteindre ces buts elle a pour objet un procédé d'attaque d'une surface d'une pièce en phosphure d'indium, comportant les opérations suivantes :

- on introduit ladite pièce dans une enceinte d'attaque munie d'électrodes,
- on introduit dans cette enceinte un mélange d'attaque gazeux contenant de l'ammoniac $NH_3$ et un gaz diluant,
- et on applique entre ces électrodes une tension électrique alternative à haute fréquence de manière à former un plasma à partir dudit mélange d'attaque,
- on soumet ladite pièce à l'action d'éléments de ce plasma en disposant lesdites électrodes de manière qu'elles forment ledit plasma au contact de ladite surface à attaquer.

De préférence, ce procédé comporte en outre une opération de nettoyage à l'aide d'un acide pour éliminer des résidus de gravure.

Le rapport de la concentration volumétrique de l'ammoniac à celle dudit gaz diluant dans ledit mélange d'attaque est de préférence compris entre 0,01 et 10,

- ladite pièce est portée à une température d'attaque comprise entre 50 et 300°C,
- la densité superficielle de la puissance appliquée par lesdites électrodes pour former ledit plasma au-dessus de ladite surface à attaquer est comprise entre 0,03 et 0,45 W/cm², 
- et la pression gazeuse dans ladite enceinte d'attaque est comprise entre $1,3.10^{-3}$, et 67 Pa environ.

De préférence encore ledit gaz diluant est majoritaire en volume dans ledit mélange d'attaque.

De préférence encore, ledit rapport de concentrations est compris entre 0,2 et 0,7, ledit gaz diluant étant l'azote,

- ladite température d'attaque est comprise entre 150 et 300°C,
- ladite densité de puissance est comprise entre 0,03 et 0,18 W/cm²,
- et ladite pression gazeuse est comprise entre 27 et 67 Pa, environ.

Dans des cas encore plus particuliers, le procédé selon l'invention est appliqué à la réalisation d'une mesa par gravure d'une face d'une plaquette monocristalline de phosphure d'indium, cette plaquette constituant ladite pièce et cette réalisation de mesa comportant les opérations suivantes :

- préparation d'une plaquette monocristalline présentant une face orientée selon un plan (001) de son réseau cristallin,
- formation sur cette face d'un masque de protection apte à résister audit plasma en laissant exposée une partie de cette face qui constitue ladite surface à attaquer, ce masque présentant un bord selon au moins une direction déterminée,
- et attaque de ladite surface par ledit plasma pour former une mesa dont un bord suit ledit bord du masque et dont le flanc correspondant présente une inclinaison qui dépend de ladite direction déterminée.

Dans ce cas on adopte de préférence l'une des dispositions suivantes selon le type de mesa souhaité :

- pour la réalisation d'une mesa dont ledit flanc est arrondi et est d'abord sensiblement perpendiculaire à ladite face à partir dudit bord puis s'incline progressivement en évasement vers l'extérieur sans plan préférentiel, ladite direction déterminée est la direction (Ī10) dudit réseau cristallin.
- pour la réalisation d'une mesa dont ledit flanc présente une première partie inclinée en surplomb vers l'intérieur à partir dudit bord, puis une deuxième partie inclinée vers l'extérieur, ladite direction déterminée est alignée sur la direction (110) du réseau cristallin, lesdites première et deuxième parties du flanc de la mesa étant orientées selon les plans (1 Ī Ī) et (1 Ī 1) respectivement.

La réalisation d'une mesa dont le flanc présente une dite deuxième partie plus longue que la première peut être effectuée en choisissant par exemple comme rapport de concentrations 0,27, comme température d'attaque 250°C, comme densité de puissance 0,044 W/cm² à une fréquence comprise entre 5 et 30 MHz, comme pression gazeuse 57 Pa (430 millitors), et en prolongeant l'attaque de ladite surface par ledit plasma au-delà de 8 minutes, environ.

A l'aide des figures schématiques ci-jointes on va décrire plus particulièrement ci-après, à titre d'exemple non limitatif, comment la présente invention peut être mise en oeuvre dans le cadre de l'exposé qui en a été donné ci-dessus.

La figure 1 a déjà été décrite et représente une vue en perspective d'une plaquette monocristalline de phosphure d'indium sur laquelle diverses mesa ont été gravées par le procédé d'attaque connu au brome méthanol.

La figure 2 représente une vue en perspective d'une plaquette monocristalline indentique sur laquelle diverses mesas ont été gravées par le procédé selon l'invention.

La figure 3 représente une vue en coupe d'un laser à hétérostructure enterrée réalisé à l'aide du procédé selon l'invention.

La figure 4 représente une vue en coupe d'un appareil pour la mise en oeuvre de ce procédé.

La gravure par plasma $NH_3$ est une gravure par voie sèche qui permet d'obtenir un profil d'attaque sensible aux plans cristallins.

La gravure par plasma $NH_3$ permet l'attaque d'une plaquette monocristalline de phosphure d'indium dont la face supérieure 210 (voir figure 2) est orientée selon un plan (001), sans plan préférentiel lorsque le masque de protection en forme de ruban est alignée selon la direction (Ī10). On obtient ainsi le flanc arrondi précédemment mentionnée, à partir du bord 214 d'une mesa 212. Dans le cas où le masque de protection est aligné sur la direction (110) on obtient dans les conditions précisées ci-après, une mesa 216 dont les flancs suivant les plans (1 Ī Ī) sur un micromètre et (1 Ī 1) sur le reste du flanc.

On va maintenant décrire un laser à hétérostructure enterrée au cours de la fabrication duquel le procédé selon la présente invention trouve avantageusement application.

Ce laser a pour fonction d'émettre une lumière infrarouge qui est destinée à être injectée dans une fibre optique de télécommunications et qui est modulée par un signal porteur d'une information à transmettre. Ce signal est appliqué entre les deux électrodes de ce laser. Ce dernier est essentiellement constitué d'une plaquette monocristalline de phosphure d'indium (matériau de base).

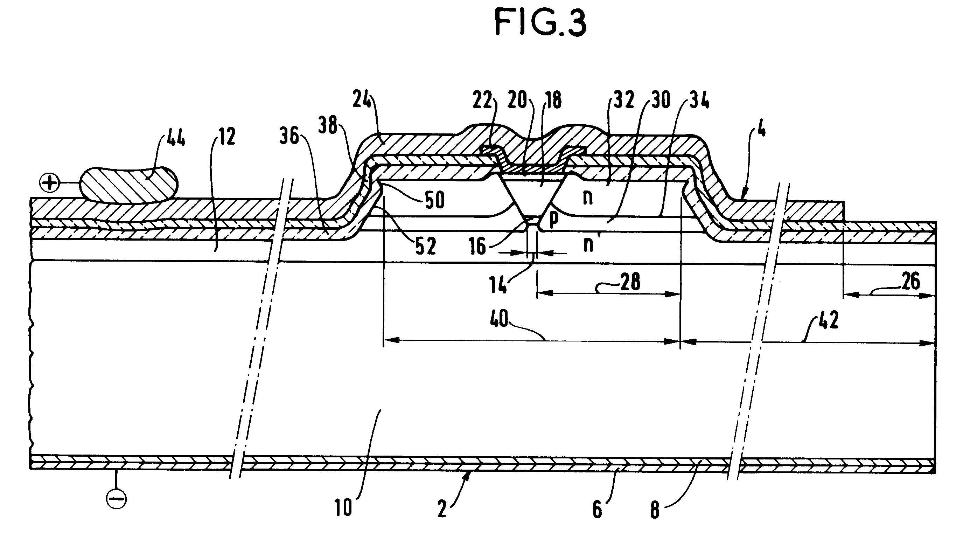

Conformément à la figure 3 il comporte, de sa face inférieure arrière 2 à sa face supérieure avant 4, et sur toute la surface de la plaquette précédemment mentionnée :

- une électrode arrière constituée d'une couche externe 6 d'alliage titane, platine, or et d'une couche interne 8 d'alliage or, germanium, nickel,

- un substrat 10 constitué de phosphure d'indium, de type de conductivité n (dopage $5,5.10^{18}$ cm$^{-3}$),

- et une couche tampon 12 de phosphure d'indium de type n (dopage Sn, $4.10^{17}$ cm$^{-3}$) épaisse de 4 micromètres dans les zones où elle n'a pas subi d'attaque.

Dans une zone médiane 14 il comporte ensuite :

- une couche active 16 qui est constituée d'arséniure et phosphure de gallium et d'indium sans dopage, et au sein de laquelle les porteurs de charges positives et négatives se recombinent pour donner naissance à ladite lumière ; cette dernière y est confinée par la différence entre l'indice de réfraction relativement élevé de cette couche et celui du matériau environnant ; elle s'en échappe partiellement à travers deux miroirs d'extrémité non représentés parallèles au plan de la feuille et formés par clivage ; les proportions des divers constituants de cette couche sont choisies de manière connue pour assurer la continuité cristalline, la valeur souhaitée de la longueur d'onde, à savoir 1,3 micromètre, et l'indice de réfraction convenable ; l'épaisseur de cette couche est de 0,2 micromètre et sa largeur de 1 à 2 micromètres ;

- une couche de confinement 18 en phosphure d'indium de type p, (dopage Zn, $2.10^{17}$ cm$^{-3}$), avec une épaisseur de 2 à 4 micromètres ; les flancs de cette couche s'évasent vers le haut en formant une mesa interne inversée, de sorte que la largeur de la face supérieure de cette couche est de 5 à 10 micromètres ; cette mesa interne est enterrée entre des couches d'ensevelissement qui seront décrites plus loin ;

- une couche de contact 20 à fort dopage p (dopage Zn, $3.10^{18}$ à $7.10^{18}$ cm$^{-3}$) constituée d'arséniure et phosphure de gallium et d'indium, la plaquette monocristalline s'étendant du substrat 10 à cette couche de contact inclusivement ;

- une couche interne d'électrode avant 22 constituée d'un alliage or-zinc et s'étendant en largeur jusqu'à faible distance seulement au-delà des couches de confinement et de contact,

- une couche métallique externe constituant ladite électrode avant 24, cette couche étant faite d'un alliage de titane, platine et or et s'étendant sur toute la surface de la plaquette sauf dans des zones de bordure telles que la zone 26 ou elle est supprimée.

Dans deux zones d'ensevelissement telles que 28 de part et d'autre de la zone médiane, le laser comporte, à partir de la couche tampon 12,

- une couche d'ensevelissement interne 30 constituée de phosphure d'indium du type p et présentant une épaisseur de 1,5 à 2 micromètres ;

- une couche d'ensevelissement externe 32 de phosphure d'indium du type n présentant une épaisseur de 2,5 à 3,5 micromètres ; la plaquette monocristalline s'arrête à cette couche qui forme avec la couche d'ensevelissement interne une jonction bloquante 34 ; les interfaces entre ces couches tampon et d'ensevelissement s'incurvent au voisinage de la zone médiane ;

- une couche de passivation 36 constituée d'un composé de silicium et d'azote tel par exemple que $Si_3N_4$ et épaisse de 0,2 micromètre ; ce composé est électriquement isolant et présente un coefficient de dilatation thermique très proche de celui du phosphure d'indium, ce qui évite l'apparition de désordre à l'interface après le dépôt de cette couche ;

- une couche de protection 38 en silice ; ces couches de passivation et de protection s'étendent sur toute la surface de la plaquette ;

- ladite électrode avant 24.

Une mesa externe est désignée par la référence 40 et occupe l'ensemble de la zone médiane 14 et des deux zones d'ensevelissement 28. Sa largeur est par exemple de 50 micromètres.

Dans deux zones latérales 42 de part et d'autre de cette mesa le laser comprend, à partir de la couche tampon 12 dont l'épaisseur est ici diminuée,

- ladite couche de passivation 36,

- ladite couche de protection 38,

- et ladite électrode avant 24 sauf dans les zones de bordure telles que 26.

Il comprend en outre, dans au moins l'une de ces deux zones latérales, un fil conducteur de connexion 44 qui est par exemple constitué d'or, et qui est soudé par compression et ultrasons sur l'électrode avant 24.

La largeur du laser est par exemple de 300 micromètres.

L'électrode arrière 6, 8 et le fil conducteur de connexion 44 sont connectés aux bornes négative et positive d'une source de tension continue modulable non représentée.

Les faces extrêmes non représentées formant miroirs sont obtenues de manière connue par clivage d'une plaquette de départ selon un plan cristallin de clivage préférentiel.

Plus précisément, par rapport au réseau cristallin du phosphure d'indium, le plan horizontal de la face avant est un plan (001) et le plan vertical transversal de la face extrême est un plan (110), la direction longitudinale qui est perpendiculaire à ce plan vertical transversal étant donc une direction (110).

Le laser ainsi constitué permet de transmettre en modulation directe un débit d'information de plusieurs gigabits par seconde.

Ce laser peut être obtenu à partir d'une plaquette monocristalline de départ par des dépôts de métaux et d'isolants et par des clivages selon des procédés bien connus. Cette plaquette peut elle même être obtenue comme il va être indiqué, étant entendu qu'on désignera par le même nom et le même numéro de référence une couche de dimensions restreintes du laser fini précédemment décrit et une couche plus étendue de même constitution à partir de laquelle la couche de dimensions restreintes est obtenue par gravure ou clivage.

On part d'un substrat 10 monocristallin et orienté (001) sur lequel on effectue des dépôts épitaxiaux selon des procédés connus pour former les couches tampon 12, active 16, de confinement 18 et de contact 20 sur toute la surface de la plaquette.

On grave ensuite ces couches à l'aide d'une solution de brome-méthanol contenant 2,5% de brome en volume pour former ladite mesa interne. Lors de cette gravure on utilise un masque de protection de type connu qui présente la forme d'un ruban orienté selon la direction (110). Il en résulte que cette direction constituera ladite direction longitudinale. Compte tenu de cette orientation la mesa ainsi formée est une mesa inversée.

Après des opérations de préparation de surfaces bien connues on dépose épitaxialement les deux dites couches d'ensevelissement 30 et 32 sur la couche tampon qui a été précédemment attaquée sur une partie de son épaisseur.

Pour réaliser ensuite ladite mesa externe par gravure on utilise un masque de protection du même type orienté selon la même direction longitudinale que précédemment. Si on appliquait alors le procédé d'attaque connu utilisant une solution de brome-méthanol on obtiendrait comme précédemment une mesa inversée. Il ne serait dans ces conditions plus possible de réaliser une passivation convenable par les procédés connus car le dépôt du matériau de passivation se ferait mal sur les flancs en retrait de la mesa. Selon la présente invention, après avoir réalisé le masque de protection selon la direction longitudinale, on utilise le procédé d'attaque qui en fait l'objet, comme il va être maintenant décrit.

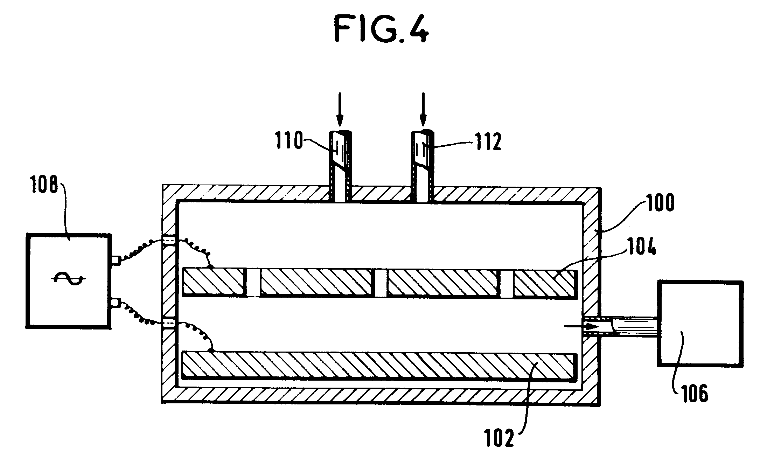

La gravure est réalisée dans un bâti par exemple du type du bâti PD80 qui est commercialisé par la société Plasma Technologie et qui est utilisé habituellement pour la mise en oeuvre du procédé de dépôt connu sous le sigle EPCVD (Enhanced Plasma Chemical Vapor Deposition en anglais). Ce bâti est représenté sur la figure 4. Il comprend :
- une enceinte 100,
- une platine chauffante inférieure 102 constituant électrode et portant les plaquettes à traiter,
- une platine supérieure 104 constituant électrode avec introduction des gaz à partir de conduits 110 et 112,
- un système de pompage 106 avec pompe primaire du type de la pompe ALCATEL 2063 commercialisée par ALCATEL CIT,
- un générateur électrique haute fréquence 108 fonctionnant à 13,56 MHz.
- et des moyens d'introduction et d'extraction des plaquettes et de refroidissement non représentés.

La gravure par plasma s'effectue à partir d'un mélange de gaz $NH_3/N_2$, l'échantillon à graver étant chauffé. Les quatre paramètres qui influent sur la vitesse de gravure sont la concentration en $NH_3$, la température de l'échantillon, la densité de puissance délivrée par le générateur et la pression de travail (pression des gaz dans l'enceinte).

Les domaines de variation sont approximativement :
- pour les concentrations un rapport $NH_3/N_2$ de 0,01 à 10, de préférence 0,2 à 0,7, en volume,
- pour la température de l'échantillon de 50 à 300°C, de préférence de 150 à 300°C,
- pour la densité de puissance de 0,03 à 0.45 $W/cm^2$, de préférence de 0,03 à 0,18 $W/cm^2$,
- pour la pression de $1,3.10^{-3}$ à 67 Pa, de préférence de 27 à 67 Pa.

Après l'attaque, dans certains cas des résidus d'indium peuvent rester sur la surface. Un nettoyage de l'échantillon avec de l'acide sulfurique redonne alors une surface propre.

A titre d'exemple, si on adopte un rapport $NH_3/N_2$ de 0,27, une température de 250°C, une densité de puissance de 0,044 $W/cm^2$ et une pression de 57 Pa, ce procédé creuse une profondeur de 6,2 micromètres en 11 minutes 30 secondes dans le phosphure d'indium.

Ce procédé assurerait une attaque sans plan préférentiel si le masque de protection en forme de ruban était orienté selon la direction transversale (Ī10) sur un substrat orienté (001). Dans le cas présent où le masque est orienté selon la direction (110) et où on adopte les valeurs indiquées ci-dessus, on obtient une mesa dont les flancs sont orientés d'abord selon un plan (1Ī1) comme pour une mesa inversée mais sur un micromètre seulement, puis selon un plan (1Ī1) sur le reste du flanc. C'est-à-dire que la mesa obtenue se rapproche beaucoup de la mesa normale souhaitée, en particulier au niveau le plus critique qui est celui de l'affleurement de la jonction bloquante 34. Sur la figure 3 la première partie minoritaire d'inclinaison inversée du flanc est représentée en 50, et la deuxième partie majoritaire d'inclinaison normale en 52.

Ce procédé présente par ailleurs les propriétés suivantes :

- obtention d'une grande résistivité de surface après attaque, c'est-à-dire que l'ordre cristallin est détruit dans une couche superficielle. Cette propriété est avantageuse lorsque, comme dans le cas présent, on veut réaliser ensuite une passivation de cette surface par un matériau amorphe notamment le composé de silicium et d'azote qui est utilisé ici,
- sélectivité de l'attaque vis-à-vis du phosphure et arséniure d'indium et de gallium In Ga As P, c'est-à-dire que ce matériau est attaqué beaucoup plus lentement que le phosphure d'indium ; ceci peut être avantageux pour la fabrication de composants semiconducteurs autres que le laser précédemment décrit ;
- simplicité de manipulation et faible toxicité des gaz utilisés.

**Revendications**

1. Procédé d'attaque d'une surface (21) d'une pièce en phosphure d'indium,comportant les opérations suivantes :
   - on introduit ladite pièce dans une enceinte d'attaque (100) munie d'électrodes (102, 104),
   - on introduit dans cette enceinte un mélange d'attaque gazeux contenant de l'ammoniac $NH_3$ et un gaz diluant,
   - et on applique entre ces électrodes une tension électrique alternative à haute fréquence de manière à former un plasma à partir dudit mélange d'attaque,
   - on soumet ladite pièce à l'action d'éléments de ce plasma en disposant lesdites électrodes (102, 104) de manière qu'elles forment ledit plasma au contact de ladite surface (21) à attaquer.

2. Procédé selon la revendication 1, caractérisé par le fait qu'il comporte en outre une opération de nettoyage à l'aide d'un acide pour éliminer des résidus de gravure.

3. Procédé selon la revendication 1, caractérisé en ce que ledit gaz diluant est majoritaire en volume dans ledit mélange d'attaque.

4. Procédé selon la revendication 1, caractérisé par le fait que
   - le rapport de la concentration volumétrique de l'ammoniac à celle dudit gaz diluant dans ledit mélange d'attaque est compris entre 0,01 et 10,
   - ladite pièce est portée à une température d'attaque comprise entre 50 et 300°C,
   - la densité superficielle de la puissance appliquée par lesdites électrodes (102, 104) pour former ledit plasma au-dessus de ladite surface à attaquer (210) est comprise entre 0,03 et 0,45 $W/cm^2$,
   - et la pression gazeuse dans ladite enceinte d'attaque est comprise entre $1,3.10^{-3}$, et 67 Pa environ.

5. Procédé selon la revendication 4, caractérisé par le fait que
   - ledit rapport de concentrations est compris entre 0,2 et 0,7, ledit gaz diluant étant l'azote,
   - ladite température d'attaque est comprise entre 150 et 300°C,
   - ladite densité de puissance est comprise entre 0,03 et 0,18 $W/cm^2$,
   - et ladite pression gazeuse est comprise entre 27 et 67 Pa, environ.

6. Procédé selon la revendication 4, appliqué à la réalisation d'une mesa (212, 40) par gravure d'une face (210, 4) d'une plaquette monocristalline de phosphure d'indium, cette plaquette constituant ladite pièce et cette réalisation de mesa comportant les opérations suivantes :
   - préparation d'une plaquette monocristalline présentant une face (210, 4) orientée selon un plan (001) de son réseau cristallin,
   - formation sur cette face d'un masque de protection apte à résister audit plasma en laissant exposée une partie de cette face qui constitue ladite surface à attaquer, ce masque présentant un bord selon au moins une direction déterminée,
   - et attaque de ladite surface par ledit plasma pour former une mesa dont un bord (214) suit ledit bord du masque et dont le flanc correspondant présente un profil qui dépend de ladite direction déterminée.

7. Procédé selon la revendication 6, pour la réalisation d'une mesa (212) dont ledit flanc est arrondi et est d'abord sensiblement perpendiculaire à ladite face (210) à partir dudit bord (214) puis s'incline progressivement en évasement vers l'extérieur sans plan préférentiel, ce procédé étant caractérisé par le fait que ladite direction déterminée est la direction ($\bar{1}$10) dudit réseau cristallin.

8. Procédé selon la revendication 6, pour la réalisation d'une mesa (40) dont ledit flanc présente une première partie (50) inclinée en surplomb vers l'intérieur à partir dudit bord, puis une deuxième partie (52) inclinée vers l'extérieur,
ce procédé étant caractérisé par le fait que ladite direction déterminée est alignée sur la direction (110), lesdites première et deuxième parties du flanc de la mesa (40) étant orientées selon les plans (1 $\bar{1}$ 1) et (1 $\bar{1}$ 1) respectivement.

9. Procédé selon la revendication 8 pour la réalisation d'une mesa dont le flanc présente une dite deuxième partie (52) plus longue que la première (50),
ce procédé étant caractérisé par le fait que ledit rapport de concentrations vaut 0,27,
   - ladite température d'attaque vaut 250°C,
   - ladite densité de puissance vaut 0,044 W/cm$^2$ à une fréquence comprise entre 5 et 30 MHz,
   - ladite pression gazeuse vaut 57 Pa,
   - et l'attaque de ladite surface par ledit plasma est prolongée au-delà de 8 minutes, environ.

**Claims**

1. A method of etching a surface (210) of an indium phosphide part, the method comprising the following operations:
   - said part is inserted in an etching enclosure (100) provided with electrodes (102, 104);
   - a gaseous etching mixture containing ammonia $NH_3$ and a diluting gas is admitted into the enclosure;
   - a high frequency alternating electric voltage is applied between said electrodes so as to form a plasma from said etching mixture;
   - said part is subjected to the action of constituents of said plasma by disposing said electrodes (102, 104) in such a manner as to form said plasma in contact with said surface (210) to be etched.

2. A method according to claim 1, characterized in that it further includes a cleaning operation using an acid to remove etching residues.

3. A method according to claim 1, characterized in that said diluting gas is a major part by volume of said etching mixture.

4. A method according to claim 1, characterized in that
   - the volume concentration ratio of the ammonia to said diluting gas in said etching mixture lies between 0.01 and 10;
   - said part is raised to an etching temperature lying between 50°C and 300°C;
   - the power surface density applied by said electrodes (102, 104) in order to form said plasma over said surface to be etched (210) lies between 0.03 W/cm$^2$ and 0.45 W/cm$^2$; and
   - the gas pressure in said etching enclosure lies between about $1.3 \times 10^{-3}$ Pa and about 67 Pa.

5. A method according to claim 4, characterized in that
   - said concentration ratio lies between 0.2 and 0.7, said diluting gas being nitrogen;
   - said etching temperature lies between 150°C and 300°C;
   - said power density lies between 0.03 W/cm$^2$ and 0.18 W/cm$^2$; and
   - said gas pressure lies between about 27 Pa and about 67 Pa.

6. A method according to claim 4, applied to making a mesa (212, 40) by etching a face (210, 4) of an indium phosphide monocrystaline wafer, said wafer constituting said part and said mesa being formed by the following operations:
   - a monocrystaline wafer is prepared having a face (210, 4) oriented on a (001) plane of its crystal lattice;
   - a protective mask for resisting said plasma is formed on said face leaving a portion of said face exposed to constitute said surface to be etched, said mask having an edge along at least one predetermined direction; and
   - etching said surface by said plasma to form a mesa having an edge (214) following said mask edge with the corresponding flank having a profile which depends on said predetermined direction.

7. A method according to claim 6 for forming a mesa (212) of which said flank is rounded and is initially substantially perpendicular to said face (210) from said edge (214) and is then progressively inclined, flaring outwardly without a preferential plane, said method being characterized in that said predetermined direction is the (110) direction of said crystal lattice.

8. A method according to claim 6, for forming a mesa (40) in which said flank has a first portion (50) at an inwardly directed undercut slope from said edge, followed by a second portion (52) which slopes outwardly, said method being characterized in that said predetermined direction is aligned with the (110) direction, and said first and second portions of the mesa flank (40) are oriented along the (111) and (111) planes respectively.

9. A method according to claim 8, for forming a mesa in which the flank has a second portion (52) which is longer than the first portion (50), said method being characterized in that
   - said concentration ratio is 0.27;
   - said etching temperature is 250°C;
   - said power density is 0.044 W/cm$^2$ at a frequency lying between 5 MHz and 30 MHz;
   - said gas pressure is 57 Pa; and
   - said surface is etched by said plasma for more than about 8 minutes.

**Patentansprüche**

1. Verfahren zum Ätzen einer Oberfläche (210) eines Körpers aus Indiumphosphid, das die folgenden Schritte aufweist:
   - man führt diesen Körper in eine Ätzkammer (100) ein, die mit Elektroden (102, 104) versehen ist,
   - man führt in diese Kammer eine gasförmige Ätzmischung ein, die Ammoniak NH$_3$ und ein Lösegas enthält,
   - und man legt zwischen diese Elektroden eine elektrische Wechselspannung hoher Frequenz an, um ausgehend von dieser Ätzmischung ein Plasma zu erzeugen,
   - man unterwirft den Körper der Einwirkung von Elementen des Plasmas, indem man die Elektroden (102, 104) so anordnet, daß sie das Plasma beim Kontakt mit der zu ätzenden Oberfläche (210) erzeugen.

2. Verfahren nach Anspruch 1, dadurch gekennzeichnet, daß es weiter einen Reinigungsvorgang mithilfe einer Säure enthält, um Ätzmittelrückstände zu beseitigen.

3. Verfahren nach Anspruch 1, dadurch gekennzeichnet, daß das Lösegas den größten Teil des Volumens in der Ätzmischung einnimmt.

4. Verfahren nach Anspruch 1, dadurch gekennzeichnet, daß
   - das Verhältnis der volumetrischen Konzentration von Ammoniak in Bezug auf die des Lösegases in der Ätzmischung zwischen 0,01 und 10 liegt,
   - der Körper auf eine Ätztemperatur zwischen 50 und 300°C gebracht wird,
   - die Dichte der an der Oberfläche wirksamen Leistung der Elektroden (102, 104), um das Plasma oberhalb der zu ätzenden Oberfläche (210) zu bilden, zwischen 0,03 und 0,45 W/cm$^2$ liegt,
   - und daß der Gasdruck in der Ätzkammer zwischen 1,3.10$^{-3}$ und etwa 67 Pa liegt.

5. Verfahren nach Anspruch 4, dadurch gekennzeichnet, daß
   - das Verhältnis der Konzentrationen zwischen 0,2 und 0,7 liegt, wobei das Lösegas Stickstoff ist,
   - die Ätztemperatur zwischen 150 und 300°C liegt,
   - die Leistungsdichte zwischen 0,03 und 0,18 W/cm$^2$ liegt
   - und der Gasdruck etwa zwischen 27 und 67 Pa liegt.

6. Verfahren nach Anspruch 4, angewandt auf die Herstellung einer Hochfläche (212, 40) durch selektives Abätzen einer Seite (210, 4) eines monokristallinen Plättchens aus Indiumphosphid, wobei dieses Plättchen den Körper bildet und die Herstellung der Hochfläche die folgenden Arbeitsschritte aufweist:
   - Vorbereitung eines monokristallinen Plättchens, von dem eine Seite (210, 4) entlang einer Ebene (001) ihrer kristallinen Struktur ausgerichtet ist,
   - Bildung einer Schutzmaske auf dieser Seite, die dem Plasma widerstehen kann, wobei ein Teil dieser Seite dem Plasma ausgesetzt bleibt und die zu ätzende Fläche bildet und wobei diese Maske einen Rand gemäß mindestens einer vorbestimmten Richtung aufweist,
   - und Ätzen der Fläche mit dem Plasma, um eine Hochfläche zu bilden, von der ein Rand (214) dem Rand der Maske folgt und deren entsprechende Flanke ein Profil aufweist, das von der vorbestimmten Richtung abhängt.

7. Verfahren nach Anspruch 6 zur Herstellung einer Hochfläche (212), deren Flanke abgerundet und zuerst im wesentlichen senkrecht zu der Seite (210) ausgehend von dem Rand (214) verläuft und sich dann zunehmend nach außen hin ausweitend neigt, ohne bevorzugte Ebene,

wobei dieses Verfahren dadurch gekennzeichnet ist, daß die vorbestimmte Richtung die Richtung ($\bar{1}$10) der kristallinen Struktur ist.

8. Verfahren nach Anspruch 6, zur Herstellung einer Hochfläche (40), deren Flanke einen ersten Bereich (50), der überhängend nach innen ausgehend von diesem Rand geneigt ist, und einen zweiten, nach außen geneigten Bereich (52) aufweist,

wobei dieses Verfahren dadurch gekennzeichnet ist, daß die vorbestimmte Richtung mit der Richtung (110) fluchtet, wobei der erste und der zweite Bereich der Flanke der Hochfläche (40) gemäß den Ebenen (1 $\bar{1}$ $\bar{1}$) bzw. (1 $\bar{1}$ 1) ausgerichtet ist.

9. Verfahren nach Anspruch 8, zur Herstellung einer Hochfläche deren Flanke einen zweiten Bereich (52) aufweist, der länger als der erste (50) ist, wobei dieses Verfahren dadurch gekennzeichnet ist, daß das Konzentrationsverhältnis 0,27 ist

- die Ätztemperatur 250°C ist,
- die Leistungsdichte 0,044 W/cm$^2$ bei einer Frequenz zwischen 5 und 30 MHz ist,
- der Gasdruck 57 Pa ist,
- und das Ätzen dieser Oberfläche durch das Plasma länger als etwa 8 Minuten dauert.

# FIG.1

# FIG.2

FIG.3

# FIG.4

EP 0 285 066 B1